Europäisches Patentamt

European Patent Office

Office européen des brevets

(19)

(11) Numéro de publication: **0 370 925**

**A1**

(12) **DEMANDE DE BREVET EUROPEEN**

(21) Numéro de dépôt: **89420458.5**

(22) Date de dépôt: **22.11.89**

(51) Int. Cl.5: **C23C 16/50, H01J 37/32, C23F 4/00**

(30) Priorité: **23.11.88 FR 8815630**

(43) Date de publication de la demande:
**30.05.90 Bulletin 90/22**

(84) Etats contractants désignés:
**CH DE FR GB IT LI NL**

(71) Demandeur: **CENTRE NATIONAL DE LA RECHERCHE SCIENTIFIQUE (CNRS)**
**15, Quai Anatole France**
**F-75700 Paris(FR)**

Demandeur: **ETAT FRANCAIS représenté par le Ministre Délégue des Postes, des Télécommunications et de l'Espace**
**-CENTRE NATIONAL D'ETUDES DES TELECOMMUNICATIONS C.N.E.T. 38-40, rue du Général Leclerc**
**F-92130 Issy-les-Moulineaux(FR)**

(72) Inventeur: **Pelletier, Jacques Henri**
**Chemin du Fort Le Mûrier**
**F-38400 St Martin D'Heres(FR)**
Inventeur: **Arnal, Yves Alban Marie**
**5, allée de la Treille**
**F-38320 Poisat(FR)**
Inventeur: **Vallier, Laurent Jean Edouard**
**3, passage des Lisses**
**F-38240 Meylan(FR)**
Inventeur: **Pichot, Michel Georges André**
**11, chemin du Couvent**
**F-38100 Grenoble(FR)**

(74) Mandataire: **Ropital-Bonvarlet, Claude**
**Cabinet BEAU DE LOMENIE 99, Grande rue de la Guillotière**
**F-69007 Lyon(FR)**

(54) **Procédé et dispositif de traitement de surface par plasma, pour un substrat porté par une électrode.**

(57) - Traitement de surface.
- Le dispositif de polarisation selon l'invention comporte :
. un générateur (5) connecté, à travers une capacité (6) de faible impédance, à une électrode (3) portant un substrat (4) et apte à délivrer une tension (V) formée d'impulsions rectangulaires, d'amplitude, de taux de répétition et de rapport cyclique variables,
. et un circuit (7) de commande du générateur permettant de sélectionner les valeurs d'amplitude, du taux de répétition et du rapport cyclique, en relation avec les paramètres à obtenir pour les opérations de traitement considérées.
- Application à la gravure d'un substrat.

Fig-1

## PROCEDE ET DISPOSITIF DE TRAITEMENT DE SURFACE PAR PLASMA, POUR UN SUBSTRAT PORTE PAR UNE ELECTRODE

La présente invention concerne les techniques pour traiter, notamment par croissance de couches, dépôt ou gravure, la surface d'un substrat isolant soumis, en particulier, à des flux de bombardement ionique et électronique d'un plasma.

L'invention vise, plus précisément, les techniques de traitement pour lesquelles le substrat est porté par une électrode, tandis que le plasma est créé indépendamment de l'électrode portant le substrat.

Pour obtenir un traitement de surface avec des caractéristiques déterminées, il convient, notamment, de contrôler le flux ionique et électronique bombardant le substrat.

L'art antérieur connaît divers procédés de contrôle du flux de bombardement, adaptés pour piloter la polarisation de l'électrode placée dans un plasma.

Le **JOURNAL PHYS. D : Appl. Phys. 19 (1986)**, pp 795-809, décrit un procédé consistant à appliquer, à travers une capacité de faible impédance, un signal symétrique sinusoïdal ou carré au substrat placé sur une électrode plongée dans un plasma continu.

Dans ce procédé, la capacité de faible impédance, placée en série avec le générateur de tension et l'électrode, permet d'assurer l'accumulation des charges (ions positifs puis électrons) sur une période et donc d'assurer l'autorégulation de la polarisation de l'électrode par rapport au potentiel plasma.

Un premier inconvénient du procédé concerne l'application d'un signal sinusoïdal lorsque la fréquence **f** du signal appliqué est inférieure ou de l'ordre de la fréquence plasma ionique **fp+**, soit $\omega < \omega_{p+}$ ($\omega = 2\pi f$), avec :

$$\omega_{p+}^2 = \frac{n_+ \, e^2}{\epsilon_o \, m_+}.$$

- $\omega_{p+}$ est la pulsation plasma ionique,
- $n_+$ est la densité d'ions positifs dans le plasma,
- $m_+$ est la masse des ions positifs,
- $\epsilon_o$ est la constante diélectrique du vide,
- **e** est la valeur absolue de la charge électronique.

Dans ce cas, la dispersion en énergie des ions frappant l'électrode est égale à la charge électronique **e** que multiplie la tension crête à crête du signal appliqué. Si cette dispersion n'est pas préjudiciable à certains traitements de surface, ce n'est pas vrai pour l'ensemble des traitements de surface.

Outre la dispersion en énergie des ions accélérés vers l'électrode dans le cas d'une autopolarisation basse fréquence ($\omega < \omega_{p+}$), ce procédé ne permet pas d'assurer un bon contrôle de la répartition dans le temps des espèces chargées qui bombardent l'électrode, à savoir les ions positifs et les électrons.

Le brevet **JP 62-77 479** du 30.09.85 enseigne de mettre en oeuvre un procédé plasma consistant à appliquer, à travers une capacité, une tension rectangulaire dissymétrique entre les deux électrodes excitatrices d'une décharge capacitive, dans le but de réduire l'énergie de bombardement des ions sur l'électrode portant le substrat à traiter. A l'évidence, ce procédé présente un premier inconvénient en ce qu'il n'est pas possible d'ajuster les durées relatives des bombardements ionique et électronique sans modifier, en même temps, l'énergie de bombardement des ions positifs sur les deux électrodes. Cet inconvénient est dû au fait que l'excitation du plasma ne peut être dissociée de l'intéraction de ce même plasma avec les électrodes. Autrement dit, dans ce type de plasma, l'équilibre global de la décharge mais aussi l'intéraction du plasma avec les électrodes dépendent, en réalité, de l'ensemble des variable externes de la décharge.

Ce procédé présente un autre inconvénient, dans la mesure où le maintien de la décharge entre les électrodes nécessite l'existence d'une tension suffisante entre les électrodes. Ainsi, une énergie de bombardement, de l'ordre de ou supérieure à 150 eV, est, généralement, requise pour produire les électrons secondaires nécessaires à l'entretien de la décharge, ce qui ne permet pas d'ajuster les durées relatives de bombardement dans le domaine des énergies de bombardement ionique inférieures à la valeur correspondant à la tension d'amorçage et de maintien de la décharge. Ce procédé rend difficile, voire impossible, dans de très nombreux cas de gravure par exemple, l'obtention d'une bonne sélectivité qui n'est possible qu'à basse énergie, c'est-à-dire en l'absence de pulvérisation.

Enfin, une diminution de la tension appliquée, c'est-à-dire de la puissance injectée dans le plasma, entraîne, corrélativement, une diminution de la densité du plasma et, par conséquent, de la vitesse de gravure.

Par ailleurs, les réactions chimiques de surface, intervenant en plasma, sont de nature électrochimique, de sorte que la répartition dans le temps des espèces chargées bombardant le substrat constitue un paramètre qu'il est nécessaire de prendre en compte pour le pilotage de la gravure et, plus généralement, des traitements de surface.

La présente invention vise à remédier aux inconvénients des procédés de l'art antérieur, en proposant un procédé de traitement de surface pour un substrat porté par une électrode et plongé dans un plasma, permettant de contrôler, à volonté et indépendamment, en relation avec le traitement de surface à exécuter, la fonction de distribution en énergie des charges ioniques positives bombardant le substrat, la répartition dans le temps des charges électroniques négatives et des charges ioniques positives bombardant le substrat et l'énergie des charges ioniques positives bombardant le substrat.

La présente invention vise à proposer un procédé de traitement permettant, en particulier, d'optimiser, d'une part, la vitesse de gravure, quel que soit le type de substrat à traiter et, d'autre part, la sélectivité de gravure de deux couches superposées.

Pour atteindre ces buts, le procédé, selon l'invention, de traitement de surface d'un substrat, consiste :
- à entretenir dans la chambre un plasma continu exempt de champs électromagnétiques,
- et à alimenter l'électrode à travers une capacité de faible impédance à l'aide d'un signal formé d'impulsions de tension de forme rectangulaire et présentant :
. un taux de répétition des impulsions variable pour contrôler la fonction de distribution en énergie des charges ioniques positives bombardant le substrat,
. un rapport cyclique de chaque impulsion variable pour commander la répartition dans le temps des charges électroniques négatives et des charges ioniques positives bombardant le substrat,
. et une amplitude des impulsions variable pour contrôler l'énergie des charges ioniques positives bombardant le substrat.

L'objet de l'invention vise, également, à proposer un dispositif pour mettre en oeuvre le procédé conforme à l'invention.

Diverses autres caractéristiques ressortent de la description faite ci-dessous en référence aux dessins annexés qui montrent, à titre d'exemples non limitatifs, des formes de réalisation de l'objet de l'invention.

La **fig. 1** est une vue schématique d'une machine de traitement équipée du dispositif adapté pour mettre en oeuvre le procédé selon l'invention.

La **fig. 2** est un diagramme montrant la forme du signal appliqué, à travers la capacité, à l'électrode portant le substrat.

Les **fig. 3** et **4** sont des tableaux montrant l'influence du procédé selon l'invention pour une opération de gravure.

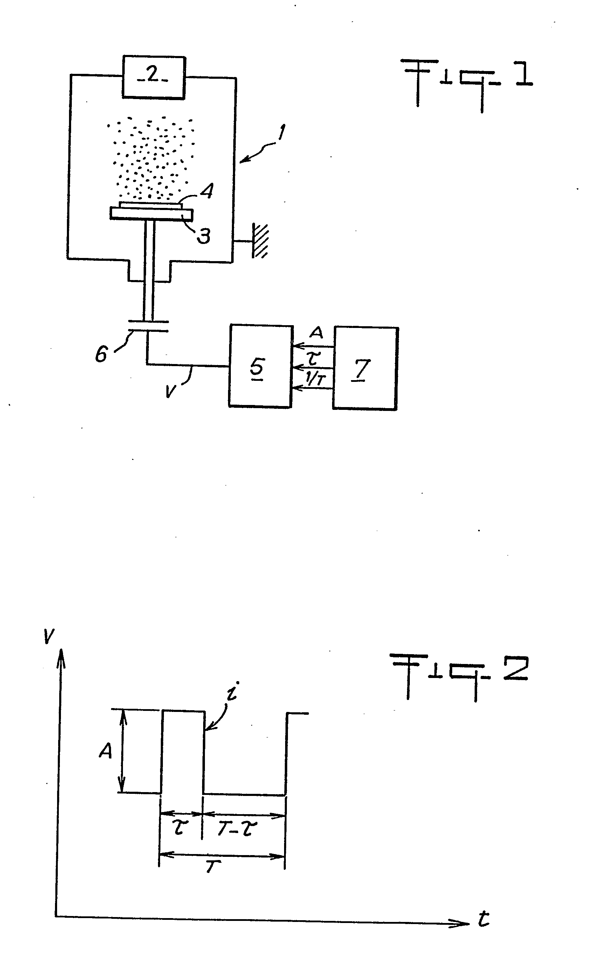

La **fig. 1** illustre une machine de traitement au sens général, de la surface d'un substrat, et équipée d'un dispositif permettant de mettre en oeuvre le procédé selon l'invention. La machine de traitement qui peut, par exemple, assurer l'exécution d'opérations de gravure ou de dépôt, comporte une enceinte étanche **1** reliée à la masse et pourvue de moyens **2** adaptés avantageusement pour produire un plasma continu exempt de champs électromagnétiques. Les moyens **2** sont de tous types connus de l'homme du métier pour produire un tel plasma pouvant être, par exemple, du type multipolaire à filament.

L'enceinte étanche **1** comporte, intérieurement, un porte-échantillon constitué par une électrode **3** destinée à porter un substrat **4** introduit par un sas, non représenté sur les dessins. Le substrat **4** est soumis à l'action du plasma, en relation avec les opérations de traitement de surface à exécuter. L'électrode **3** est polarisée par rapport au potentiel plasma à l'aide d'un dispositif conforme à l'invention, qui est totalement indépendant des moyens **2** de production du plasma.

Le dispositif de polarisation selon l'invention comporte, d'une part, un générateur **5** connecté à l'électrode **3** à travers une capacité **6** de faible impédance et, d'autre part, un circuit **7** de commande du générateur **5** dont la fonction apparaîtra plus clairement dans la description qui suit.

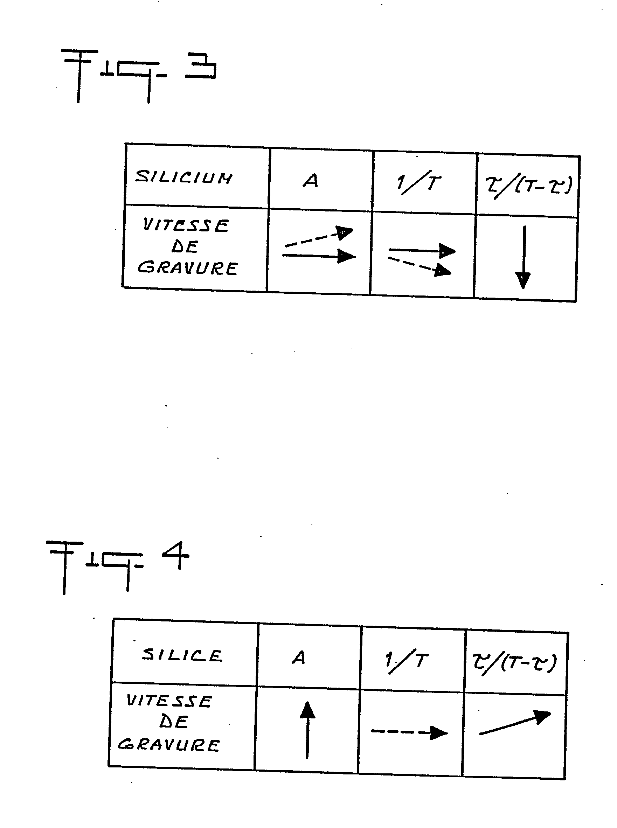

Tel que cela ressort plus précisément de la **fig. 2**, le générateur **5** est apte à délivrer un signal $\underline{V}$ formé d'impulsions $\underline{i}$ de tension de forme rectangulaire de taux de répétition **1/T**, de largeur $\tau$ et d'amplitude $\underline{A}$. Conformément à l'invention, le signal $\underline{V}$ comporte un taux de répétition **1/T** des impulsions, un rapport cyclique $\tau/(T - \tau)$ et une amplitude $\underline{A}$ variables, permettant de contrôler le flux électronique et ionique bombardant le substrat **4**.

Ainsi, le réglage du taux de répétition **1/T** des impulsions assure le contrôle de la fonction de distribution en énergie des charges positives bombardant le substrat, tandis que le réglage du rapport cyclique $\tau/(T - \tau)$ de chaque impulsion permet de commander la répartition dans le temps des charges électroniques négatives et des charges ioniques positives bombardant le substrat. De plus, le réglage de l'amplitude $\underline{A}$ des impulsions autorise le contrôle de l'énergie $\overline{W}+$ des charges ioniques positives bombardant le substrat.

Si la forme des impulsions $\underline{i}$ appliquées à l'électrode n'est pas réellement rectangulaire, mais avec des temps de montée et de descente modérées par rapport à la longueur des impulsions, l'efficacité du traitement reste pratiquement irchangée. Par conséquent, il doit être entendu, dans la suite de la description, par signal de forme rectangulaire, tout signal dont la forme réelle reste proche de la forme rectangulaire.

Le circuit de commande **7** permet de sélectionner les valeurs d'amplitude **A,** du taux de répétition **1/T** et du rapport cyclique $\overline{\tau}/(T - \tau)$ des impulsions du signal, en relation avec les paramètres à obtenir pour les opérations de traitement considérées.

Avantageusement, le taux de répétition des impulsions est réglable, de part et d'autre de la fréquence plasma ionique, et se trouve, de préférence, maintenu constant dans le temps pour une opération de traitement donnée.

Si le taux de répétition des impulsions est supérieur à la fréquence plasma ionique $f_{p+}$, l'énergie $W_+ = e (V_p - V_o)$ est constante dans le temps. Si la température électronique est faible, telle que $eA \gg kT_e$ et si le rapport cyclique ne prend pas des valeurs extrêmes, soit, par exemple, $1/20 < \tau/(T - \tau) < 20$, le calcul donne :

$$V_p - V_o \simeq - V_f + A((T - \tau)/T) + (kT_e/e) \ln \tau/T$$

où :
- $V_p$ est le potentiel plasma,
- $V_o$ est la tension d'autopolarisation,
- $V_f$ est le potentiel flottant du plasma,
- $A$ est l'amplitude des impulsions,
- $k$ est la constante de Boltzmann,
- $T_e$ est la température électronique du plasma,
- $\tau$ est la durée de l'impulsion positive,
- $1/T$ est le taux de répétition des impulsions.

Pour peu que $\ln \tau/T$ ne dépasse pas quelques unités, l'ordre de grandeur de l'énergie des ions est :
$$W_+ \simeq e(V_p - V_o) = eA((T - \tau)/T)$$

Avantageusement, le rapport cyclique de chaque impulsion est donc compris, de préférence, entre 1/20 et 20 et se trouve maintenu constant dans le temps pour une opération de traitement donnée.

Pour illustrer, à titre d'exemple, le procédé de traitement selon l'invention, la **fig. 3** décrit l'influence qualitative de l'accroissement de l'amplitude, du taux de répétition et du rapport cyclique du signal électrique **V** sur les paramètres de gravure.

Dans le cas de la gravure, par des gaz halogénés d'un substrat réalisé en silicium, il apparaît une réaction d'oxydation favorisée par le bombardement des charges ioniques positives, mais fortement inhibée en présence d'un bombardement de charges électroniques négatives. Il convient donc de pouvoir régler le rapport cyclique du signal pour piloter la répartition dans le temps des espèces bombardant le substrat, de manière à obtenir l'optimisation, à énergie donnée, de la vitesse de gravure d'un substrat donné.

Ainsi, la vitesse de gravure du silicium, dans un plasma de gaz fluoré, croît faiblement avec l'augmentation de l'amplitude **A,** décroît faiblement avec l'augmentation du taux de répétition et chute brutalement avec l'accroissement du rapport cyclique.

Dans le cas de la gravure par du fluor, d'un substrat réalisé en silice, il apparaît que la gravure de la silice peut être favorisée, aussi bien par les charges ioniques que par les charges électroniques négatives bombardant le substrat, pour un seuil en énergie différent concernant les charges ioniques et les charges électroniques. Ainsi, le pilotage de la gravure de la silice impose de pouvoir régler, d'une part, le taux de répétition du signal pour contrôler la fonction de distribution en énergie des charges ioniques et, d'autre part, le rapport cyclique pour commander la répartition dans le temps des charges électroniques et des charges ioniques positives attaquant le substrat.

Tel que cela ressort de la **fig. 4,** la vitesse de gravure de la silice croît avec l'augmentation de l'amplitude, augmente avec l'accroissement du rapport cyclique et reste sensiblement constante, en relation avec l'augmentation du taux de répétition.

La sélectivité de gravure du silicium par rapport à la silice et, inversement, découle directement des résultats énoncés ci-dessus.

Ainsi, si la sélectivité de gravure du silicium, par rapport à la silice, doit être améliorée, il convient d'augmenter la durée de bombarderment des charges ioniques positives et réduire, corrélativement, la durée de bombardement des charges électroniques. A cet effet, le taux de répétition **1/T** doit être supérieur à la fréquence plasma ionique et la largeur $\tau$ de l'impulsion doit être nettement inférieure à la période **T** du signal.

Inversement, si la sélectivité de gravure de la silice par rapport au silicium doit être favorisée, il convient de diminuer la durée de bombardement des charges ioniques au profit de la durée de bombardement des charges électroniques. A cet effet, le taux de répétition doit être inférieur à la fréquence plasma ionique, tandis que la période **T** doit être largement supérieure à la différence entre la période et la largeur de l'impulsion.

Il apparaît donc clairement que le dispositif selon l'invention permet de piloter les opérations de gravure, quelle que soit la nature du substrat et les paramètres de gravure à obtenir.

Le cas de la silice et du silicium a été présenté à titre d'exemple, mais l'optimisation de la vitesse de gravure de tout substrat et de la sélectivité de gravure de deux couches superposées peut être pilotée en agissant sur les trois paramètres du signal appliqué à l'électrode.

Les exemples décrits ci-dessus concernent, principalement, les opérations de gravure, mais il doit être considéré, bien entendu, que le procédé selon l'invention peut être mis en oeuvre pour les traitements de surface par plasma, au sens général et, en particulier, aux dépôts.

## Revendications

1 - Procédé de traitement de surface pour un substrat (4) porté par une électrode (3) et plongé dans une enceinte étanche (1) de gravure ou de dépôt dans laquelle des moyens (2) produisent un plasma, du type consistant à appliquer à l'électrode une tension variable produite par un générateur indépendant des moyens de production du plasma, caractérisé en ce qu'il consiste :
- à entretenir dans la chambre un plasma continu exempt de champs électromagnétiques,
- et à alimenter l'électrode à travers une capacité de faible impédance à l'aide d'un signal ($\underline{V}$) formé d'impulsions ($\underline{i}$) de tension de forme rectangulaire et présentant :
. un taux de répétition (**1/T**) des impulsions variable pour contrôler la fonction de distribution en énergie des charges ioniques positives bombardant le substrat,
. un rapport cyclique ($\tau/(\mathbf{T} - \tau)$) de chaque impulsion variable pour commander la répartition dans le temps des charges électroniques négatives et des charges ioniques positives bombardant le substrat,
. et une amplitude (**A**) des impulsions variable pour contrôler l'énergie des charges ioniques positives bombardant le substrat.

2 - Procédé selon la revendication 1, caractérisé en ce que le taux de répétition (**1/T**) des impulsions est constant dans le temps pour une opération de traitement donnée.

3 - Procédé selon la revendication 1, caractérisé en ce que le taux de répétition (**1/T**) des impulsions est réglable de part et d'autre de la fréquence plasma ionique.

4 - Procédé selon la revendication 1, caractérisé en ce que le rapport cyclique ($\tau/(\mathbf{T} - \tau)$) est constant dans le temps pour une opération de traitement donnée.

5 - Procédé selon la revendication 1 ou 4, caractérisé en ce que le rapport cyclique ($\tau/(\mathbf{T} - \tau)$) de chaque impulsion est compris, de préférence, entre 1/20 et 20.

6 - Procédé selon la revendication 1, caractérisé en ce qu'il consiste à alimenter l'électrode à l'aide d'un signal périodique.

7 - Dispositif de polarisation pour mettre en oeuvre le procédé selon les revendications 1 à 6, caractérisé en ce qu'il comporte :
- un générateur (5) connecté, à travers une capacité (6) de faible impédance, à une électrode (3) portant un substrat (4) et apte à délivrer une tension ($\underline{V}$) formée d'impulsions rectangulaires, d'amplitude, de taux de répétition et de rapport cyclique variables,
- et un circuit (7) de commande du générateur permettant de sélectionner les valeurs d'amplitude, du taux de répétition et du rapport cyclique, en relation avec les paramètres à obtenir pour les opérations de traitement considérées.

8 - Dispositif de polarisation selon la revendication 7, caractérisé en ce que le générateur (5) delivre une tension périodique ($\underline{V}$).

Fig. 1

Fig. 2

# Fig. 3

| SILICIUM | A | 1/T | $\tau/(T-\tau)$ |
|---|---|---|---|
| VITESSE DE GRAVURE | | | |

# Fig. 4

| SILICE | A | 1/T | $\tau/(T-\tau)$ |
|---|---|---|---|
| VITESSE DE GRAVURE | | | |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-C-3 733 135 (LEYBOLD AG) * Revendications 1-5 * | 1-4,6-8 | C 23 C 16/50 H 01 J 37/32 C 23 F 4/00 |
| A,D | JOURNAL OF PHYSICS D: APPLIED PHYSICS, vol. 19, no. 5, 14 mai 1986, pages 795-809, The Institute of Physics, Londres, GB; J. PELLETIER et al.: "Les plasmas multipolaires micro-onde: une solution pour la gravure en microelectronique?" * Pages 802-804 * | 1 | |

**DOMAINES TECHNIQUES RECHERCHES (Int. Cl.5)**

C 23 C
C 23 F
H 01 J

Le présent rapport a été établi pour toutes les revendications

| Lieu de la recherche | Date d'achèvement de la recherche | Examinateur |
|---|---|---|
| LA HAYE | 28-02-1990 | PATTERSON A.M. |

EPO FORM 1503 03.82 (P0402)